# EUROPEAN PATENT SPECIFICATION

(11) **EP 0 966 104 B1**
(45) Date of publication and mention of the grant of the patent: **13.10.2004**
(21) Application number: 99108762.8
(22) Date of filing: 03.05.1999
(51) Int. Cl.: H03M 1/08, H03M 1/16

(54) **Cascade A/D converter**
Kaskadierter Analog-Digital-Wandler
Convertisseur analogique-numérique du type en cascade

(30) Priority: 16.06.1998 JP 16853298; 09.02.1999 JP 3133799; 15.02.1999 JP 3557799; 15.02.1999 JP 3558399; 15.02.1999 JP 3558499
(43) Date of publication of application: 22.12.1999
(73) Proprietor: Yokogawa Electric Corporation, Tokyo 180-8750 (JP)
(72) Inventor: Irie, Koichi, c/o Yokogawa Electric Corporation, Musashino-shi, Tokyo 180-8750 (JP); Kusayanagi Naoya, c/o Yokogawa Electric Corp., Musashino-shi, Tokyo 180-8750 (JP)
(74) Representative: Henkel, Feiler & Hänzel

(56) References cited:
- US-A- 5 465 092
- US-A- 5 677 692
- PATENT ABSTRACTS OF JAPAN vol. 1998, no. 01, 30 January 1998 (1998-01-30) & JP 09 238077 A (YOKOGAWA ELECTRIC CORP), 9 September 1997 (1997-09-09)
- LEWIS S H ET AL: "A pipelined 9-stage video-rate analog-to-digital converter" PROCEEDINGS OF THE CUSTOM INTEGRATED CIRCUITS CONFERENCE. SAN DIEGO, MAY 12 - 15, 1991, NEW YORK, IEEE, US, vol. CONF. 13, 12 May 1991 (1991-05-12), pages 264-1-264-4, XP010044559 ISBN: 0-7803-0015-7
- KHAYROLLAH HADIDI ET AL: "ERROR ANALYSIS IN PIPELINE A/D CONVERTERS AND ITS APPLICATIONS" IEEE TRANSACTIONS ON CIRCUITS AND SYSTEMS II: ANALOG AND DIGITAL SIGNAL PROCESSING, IEEE INC. NEW YORK, US, vol. 39, no. 8, 1 August 1992 (1992-08-01), pages 506-515, XP000322041 ISSN: 1057-7130

## Description

### BACKGROUND OF THE INVENTION

### 1. Field of the Invention

The present invention relates to a cascade A/D converter that can be operated without error using one clock, and in particular, to the cascade A/D converter that can prevent generation of errors due to noise.

### 2. Description of the Prior Art

A/D converters include a type of cascade A/D converter of small circuit scale, low power consumption, and low input capacity. Operating this type of cascade A/D converter using one clock provides high-speed operation. However, there is a problem of error generation in such operations. Accordingly, the applicants of the present invention invented a cascade A/D converter that can be operated without errors using one clock. This invention has been disclosed in the publication of unexamined patent applications, Hei 9-238077 (1997).

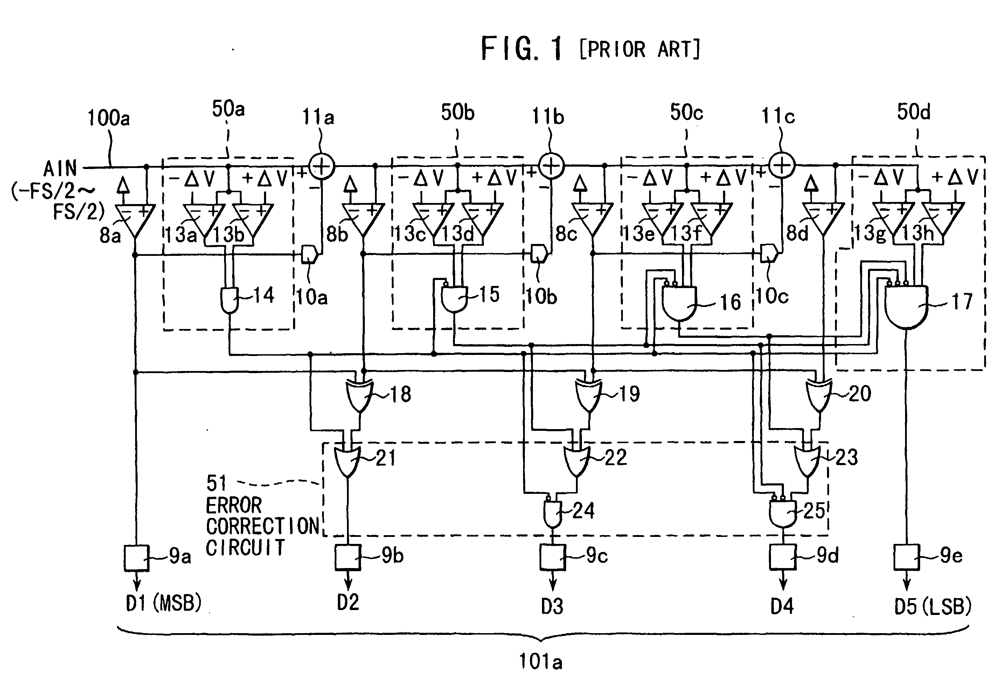

Such a device is described using Figure 1. The device in this figure shows a cascade 5-bit A/D converter that outputs the alternate binary code (hereafter called gray code) as an example.

In Figure 1, numerals 8a to 8d show comparators, numerals 9a to 9e latch circuits, numerals 10a to 10c D/A converters, and numerals 11a to 11c subtracters. Numerals 13a to 13h show comparators, numerals 14 to 17 logical product circuits (hereafter called AND circuits), numerals 18 to 20 exclusive logical sum circuits (hereafter called EOR circuits), numerals 21 to 23 logical sum circuits (hereafter called OR circuits), numerals 24 and 25 logical product circuits (hereafter called AND circuits), numeral 100a an analog input signal, and numeral 101a a digital output signal.

Comparators 13a, 13b and AND circuit 14 compose window comparator 50a. Comparators 13c, 13d and AND circuit 15 compose window comparator 50b. Comparators 13e, 13f and AND circuit 16 compose window comparator 50c. Comparators 13g, 13h and AND circuit 17 compose window comparator 50d. OR circuits 21 to 23 and AND circuits 24 and 25 compose error correction circuit 51.

Analog input signal 100a is input to each non-inverted input terminal of comparators 8a and 13a, inverted input terminal of comparator 13b and the addition input terminal of subtracter 11a.

The output of comparator 8a is connected to latch circuit 9a, D/A converter 10a, and one input terminal of EOR circuit 18 and the output of D/A converter 10a is connected to the subtraction input terminal of subtracter 11a.

Also, the outputs of comparators 13a and 13b are connected to the input terminals of AND circuit 14. The output of AND circuit 14 is connected to one input terminal of OR circuit 21 and negative logic input terminals of AND circuits 15 to 17, 24, and 25.

The output of subtracter 11a is connected to each non-inverted input terminal of comparators 8b and 13c, inverted input terminal of comparator 13d and the addition input terminal of subtracter 11b.

The output of comparator 8b is connected to D/A converter 10b, the other input terminal of EOR circuit 18, and one input terminal of EOR circuit 19 and the output of D/A converter 10b is connected to the subtraction input terminal of subtracter 11b.

Also, each output of comparators 13c and 13d is connected to the other two positive logic input terminals of AND circuit 15 respectively. The output of AND circuit 15 is connected to one input terminal of OR circuit 22 and each of the negative logic input terminals of AND circuits 16, 17, and 25.

In addition, the output of EOR circuit 18 is connected to the other input terminal of OR circuit 21 and the output of OR circuit 21 is connected to latch circuit 9b.

The output of subtracter 11b is connected to each non-inverted input terminal of comparators 8c and 13e, the inverted input terminal of comparator 13f, and the addition input terminal of subtracter 11c.

The output of comparator 8c is connected to D/A converter 10c, the other input terminal of EOR circuit 19, and one input terminal of EOR circuit 20, and the output of EOR circuit 19 is connected to the other input terminal of OR circuit 22. The output of OR circuit 22 is connected to the positive logic input terminal of AND circuit 24 and the output of AND circuit 24 is connected to latch circuit 9c.

Also, each output of comparators 13e and 13f is connected to the other two positive logic input terminals of AND circuit 16 respectively, and the output of AND circuit 16 is connected to one input terminal of OR circuit 23 and the negative logic input terminal of AND circuit 17.

The output of subtracter 11c is connected to the non-inverted input terminals of comparators 8d and 13g and the inverted input terminal of comparator 13h.

The output of comparator 8d is connected to the other input terminal of EOR circuit 20 and the output of EOR circuit 20 is connected to the other input terminal of OR circuit 23. The output of OR circuit 23 is connected to the positive logic input terminal of AND circuit 25 and the output of AND circuit 25 is connected to latch circuit 9d.

Also, each output of comparators 13g and 13h is connected to the other two positive logic input terminals of AND circuit 17 respectively and the output of AND circuit 17 is connected to latch circuit 9e.

In addition, the outputs of latch circuits 9a to 9e are output as digital output signal 101a.

Further, inverted input terminals of comparators 8a to 8d are grounded and the voltage of +ΔV is applied to the non-inverted input terminals of comparators 13b, 13d, 13f, and 13h and the voltage of -ΔV to the inverted input terminals of comparators 13a, 13c, 13e, and 13g respectively. However, ΔV = FS/32 (FS: full scale).

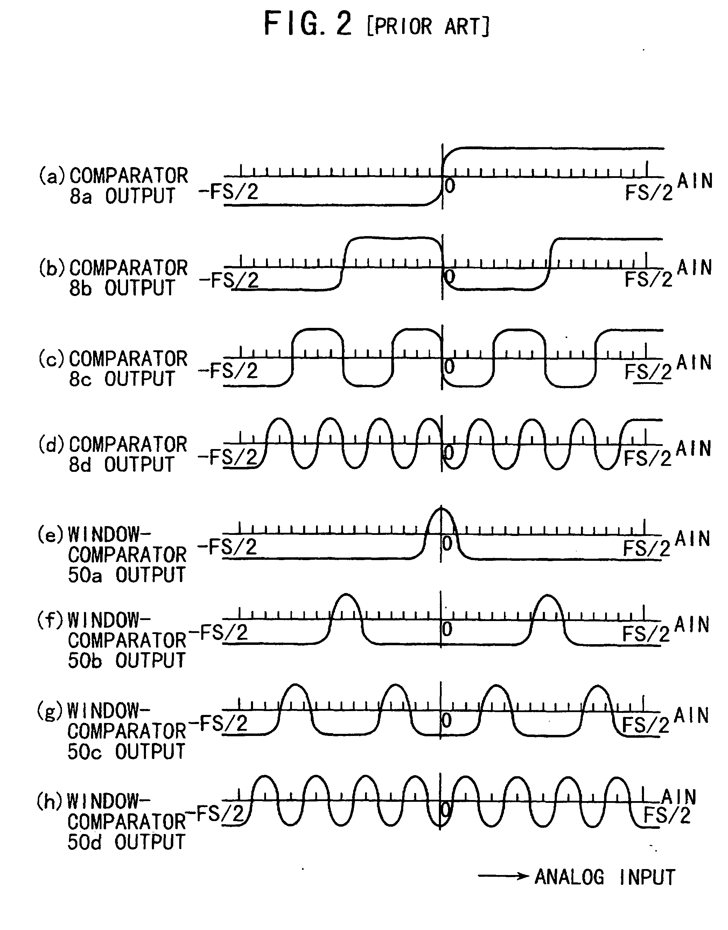

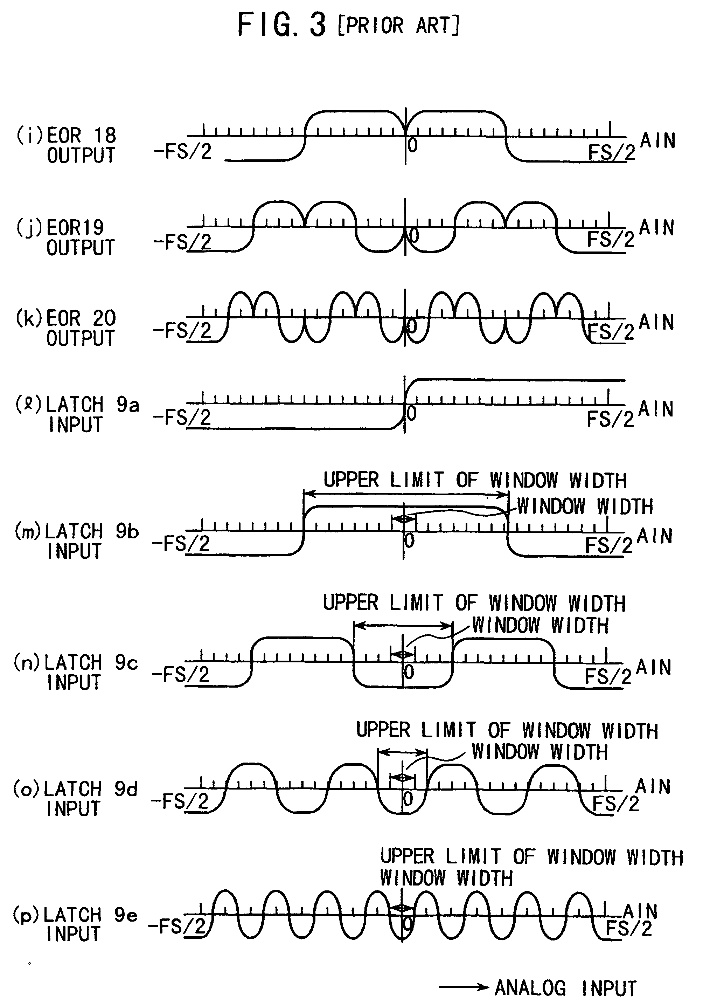

Now, operation of the device shown in Figure 1 will be described using Figures 2 and 3. Figures 2 and 3 show characteristic curves that indicate each output or each input for analog input signal 100a from -FS/2 to +FS/2.

In Figures 2 and 3, curves (a) to (d) represent the outputs of comparators 8a to 8d, and curves (e) to (h) the outputs of window comparators 50a to 50d. Further, curves (i) to (k) represent the outputs of EOR circuits 18 to 20, and curves (l) to (p) the inputs of latch circuits 9a to 9e, respectively.

Comparators 8a to 8d judge zero-crossing of analog input signal 100a, the output of subtracter 11a, the output of subtracter 11b, and the output of subtracter 11c respectively.

Each of window comparators 50a to 50d outputs a "high level" signal if the input signal is in each vicinity of "zero" and the output of the window comparator at the preceding stage is a "low level" signal.

Hence, window comparator 50a outputs a "high level" signal if analog input signal 100a is in each vicinity of "zero" as shown in (e) of Figure 2.

Window comparator 50b may possibly output a "high level" signal when analog input signal 100a is in each vicinity of "zero" and "±FS/4" as shown in (b) of Figure 2. However, since the output of window comparator 50a at the preceding stage is at "high level" when analog input signal 100a is in each vicinity of "zero," window comparator 50b outputs "high level" signals only in each vicinity of "±FS/4" as shown in (f) of Figure 2.

Window comparator 50c may possibly output a "high level" signal in seven positions as shown in (c) of Figure 2. However, since the positions where window comparator 50a or 50b at the previous stages outputs a "high level" signal are rejected, the output of window comparator 50c indicates the form shown in (g) of Figure 2.

Similar to the above, window comparator 50d may possibly output a "high level" signal in 15 positions as shown in (d) of Figure 2. However, since the positions where window comparator 50a, 50b or 50c at the previous stages outputs a "high level" signal are rejected, the output of window comparator 50d indicates the form shown in (h) of Figure 2.

The outputs of EOR circuits 18 to 20 send out gray codes of intermediate bits in digital output signal 101a but it is known that they generate spike-like noise as shown in (i) to (k) of Figure 3. It is caused by the fact that changes from "high level" to "low level" or from "low level" to "high level" in the outputs of comparators 8a to 8d are not steep.

Error correction circuit 51 herein rejects the above spike-like noise as shown in (m) to (o) of Figure 3 by correcting the portions where the above spike-like noise is generated using the outputs of window comparators.

That is, spike-like noise shown in (i), (j), and (k) of Figure 3 is rejected by being masked with the output of window comparator 50a, the outputs of window comparators 50a and 50b, and the outputs of window comparators 50a, 50b, and 50c respectively.

The outputs of window comparators 50a to 50c in this device have an action to change to "high level" in a certain region (hereafter called window width) near the code changing points to establish all lower codes.

Considering the first stage window comparator 50a, the second bit is forced to "high level" and the third bit, fourth bit and the least significant bit (LSB) (the fifth bit) are forced to "low level" near the changing point for the most significant bit (MSB).

The window widths for establishing each bit are not required to be the same essentially. As shown in (m) of Figure 3, the region to force the second bit to "high level" can be allowed up to a half of full scale and, as shown in (n) of Figure 3, up to 1/4 of full scale can be allowed for the third bit. The allowable window width becomes narrower as the bit becomes lower and at LSB, as shown in (p) of Figure 3, the upper limit of window width becomes 1/16 of full scale, or 2LSB.

However, since window comparator 50a that detects the changing points for MSB propagates its output to the lower bits, the window width cannot but be constant. For example, the window width for making the second bit "high level" at the MSB changing point is made the same as the window width for carrying LSB to "low level."

For this reason, there is a problem that, when the window width comes near the noise level with high resolution, an error is generated in the code of the second bit in the worst case where window comparator 50a malfunctions due to noise.

An A/D-converter according to Fig. 1 is disclosed in JP-A-08322709.

Stephen H. Lewis ET AL: "A pipelined 9-stage video-rate analog-to-digital converter", XP010044559 and Khayrollah Fiadidi ET AL: "Error analysis in pipeline A/D converters and its applications", XP000322041 disclose respective A/D-converters showing the use of ADSC-offsets to shift the location of the decision level and disclosing an error corrected A/D-stage.

### SUMMARY OF THE INVENTION

The objective of the present invention is to realize a cascade A/D converter that can prevent error generation due to noise.

The above object is achieved by a A/D-converter according to claim 1. The dependent claims are directed to further advantageous aspects of the present invention.

### BRIEF DESCRIPTION OF THE DRAWINGS

Figure 1 shows a configuration drawing that indicates a conventional cascade A/D converter.
Figure 2 is a diagram including characteristic curves illustrating operations of the device shown in Figure 1.
Figure 3 is also a diagram including characteristic curves illustrating operations of the device shown in Figure 1.
Figure 4 shows a configuration drawing that indicates a first embodiment of the present invention.
Figure 5 is a diagram including characteristic curves illustrating operations of the device shown in Figure 4.
Figure 6 is also a diagram including characteristic curves illustrating operations of the device shown in Figure 4.
Figure 7 shows a configuration drawing that indicates a second embodiment of the present invention.
Figure 8 is a diagram including characteristic curves illustrating operations of the device shown in Figure 7.
Figure 9 is also a diagram including characteristic curves illustrating operations of the device shown in Figure 7.
Figure 10 is another diagram including characteristic curves illustrating operations of the device shown in Figure 7.
Figure 11 is also another diagram including characteristic curves illustrating operations of the device shown in Figure 7.
Figure 12 shows a configuration drawing that indicates a third embodiment of the present invention.
Figure 13 is a diagram including characteristic curves illustrating operations of the device shown in Figure 12.
Figure 14 is also a diagram including characteristic curves illustrating operations of the device shown in Figure 12.
Figure 15 is another diagram including characteristic curves illustrating operations of the device shown in Figure 12.
Figure 16 shows a configuration drawing that indicates a fourth embodiment of the present invention.
Figure 17 is a diagram including characteristic curves illustrating operations of the device shown in Figure 16.
Figure 18 shows a configuration drawing indicating another embodiment of the window comparator.

### DETAILED DESCRIPTION OF THE PREFERRED EMBODIMENTS

The present invention will be described below using the drawings.

### (1) First Embodiment

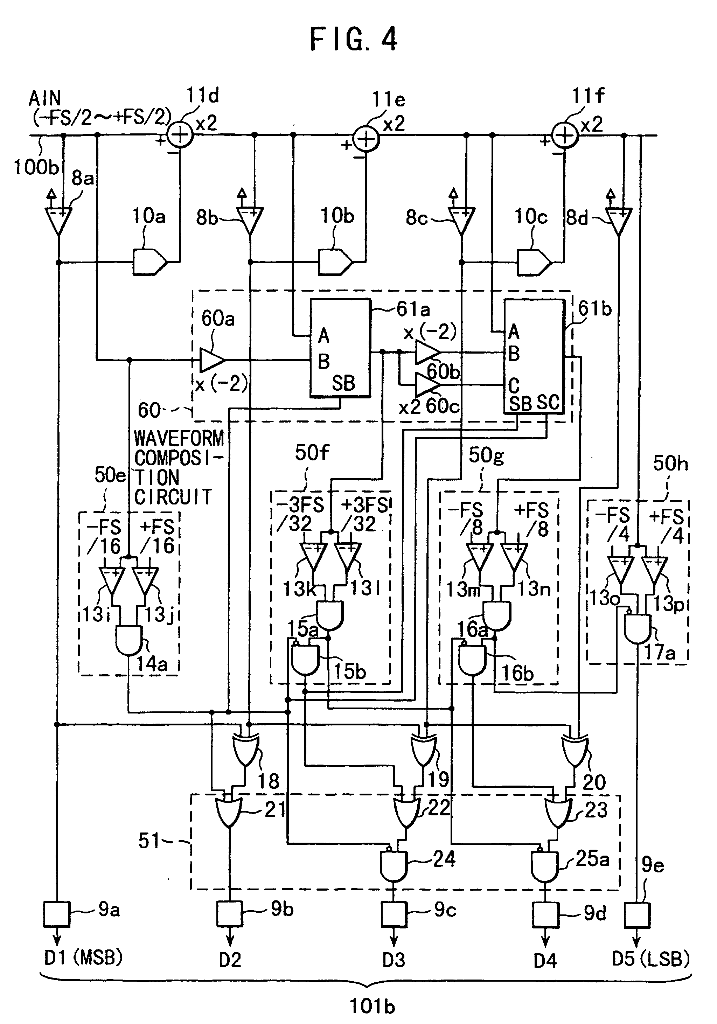

Figure 4 shows a configuration drawing that indicates a first embodiment of the present invention. In this figure, to the components identical to those shown in Figure 1, the same signs as those in Figure 1 are given and so description of those will be omitted.

In Figure 4, numerals 11d to 11f show subtracters, numerals 13i to 13p comparators, numerals 14a, 15a, 15b, 16a, 16b, 17a and 25a logical product circuits (hereafter called AND circuits), numerals 60a to 60c amplifiers, and numerals 61a and 61b analog multiplexers. In addition, numeral 100b is an analog input signal, and 101b a digital output signal.

Further, comparators 13i and 13j and AND circuit 14a compose window comparator (means for detecting each vicinity of code changing points) 50e. Comparators 13k and 13l and AND circuit 15a and 15b compose window comparator (means for detecting each vicinity of code changing points) 50f. Comparators 13m and 13n and AND circuit 16a and 16b compose window comparator (means for detecting each vicinity of code changing points) 50g. Comparators 13o and 13p and AND circuit 17a compose window comparator (means for detecting each vicinity of code changing points) 50h. Amplifiers 60a to 60c and analog multiplexers 61a and 61b compose waveform composition circuit 60.

As for connections, the basic part is the same as those in Figure 1 and the differences are as follows:

Subtracters 11d to 11f are provided in place of subtracters 11a to 11c and send out each output after amplifying twice the subtraction result respectively.

Analog input signal 100b is input to the non-inverted input terminals of comparators 8a and 13i, the inverted input terminal of comparator 13j, the addition input terminal of subtracter 11d, and amplifier 60a.

In addition, the outputs of comparators 13i and 13j are connected to the input terminals of AND circuit 14a respectively. The output of AND circuit 14a is connected to one input terminal of OR circuit 21, negative logic input terminals of AND circuits 15b and 24, the selection terminal of analog multiplexer 61a, and one selection terminal of analog multiplexer 61b.

The output of amplifier 60a is input to one input terminal of analog multiplexer 61a.

The output of subtracter 11d is connected to the non-inverted terminal of comparator 8b, addition input terminal of subtracter 11e, and the other input terminal of analog multiplexer 61a. The output of analog multiplexer 61a is connected to the non-inverted input terminal of comparator 13k, the inverted input terminal of comparator 13l, and amplifiers 60b and 60c respectively.

Also, outputs of comparators 13k and 13l are connected to AND circuit 15a respectively. The output of AND circuit 15a is connected to the positive logic input terminal of AND circuit 15b and the negative logic input terminals of AND circuits 16b and 25a. The output of AND circuit 15b is connected to one input terminal of OR circuit 22 and the other selection terminal of analog multiplexer 61b. The output of OR circuit 23 is connected to the positive logic input terminal of AND circuit 25a and the output of AND circuit 25a is connected to latch circuit 9d.

The outputs of amplifiers 60b and 60c are input to the input terminals of analog multiplexer 61b respectively.

The output of subtracter 11e is connected to the non-inverted input terminal of comparator 8c, the addition input terminal of subtracter 11f, and the input terminal of analog multiplexer 61b. The output of analog multiplexer 61b is connected to the non-inverted input terminal of comparator 13m and the inverted input terminal of comparator 13n.

In addition, the outputs of comparators 13m and 13n are connected to the input terminals of AND circuit 16a respectively. The output of AND circuit 16a is connected to the positive logic input terminal of AND circuit 16b and the negative logic input terminal of AND circuit 17a. The output of AND circuit 16b is connected to one input terminal of OR circuit 23.

The output of subtracter 11f is connected to the non-inverted input terminals of comparators 8d and 13o and the inverted input terminal of comparator 13p.

Further, the outputs of comparators 13o and 13p are connected to the other two positive logic input terminals of AND circuit 17a respectively and the output of AND circuit 17a is connected to latch circuit 9e.

Furthermore, outputs of latch circuits 9a to 9e are output as a digital signal 101b.

Voltages of +FS/16, +3FS/32, +FS/8, and +FS/4 are applied to the non-inverted input terminals of comparators 13j, 13l, 13n, and 13p respectively. Also, voltages of -FS/16, -3FS/32, -FS/8, and -FS/4 are applied to the inverted input terminals of comparators 13i, 13k, 13m, and 13o respectively.

Operations of such a device will be described below.

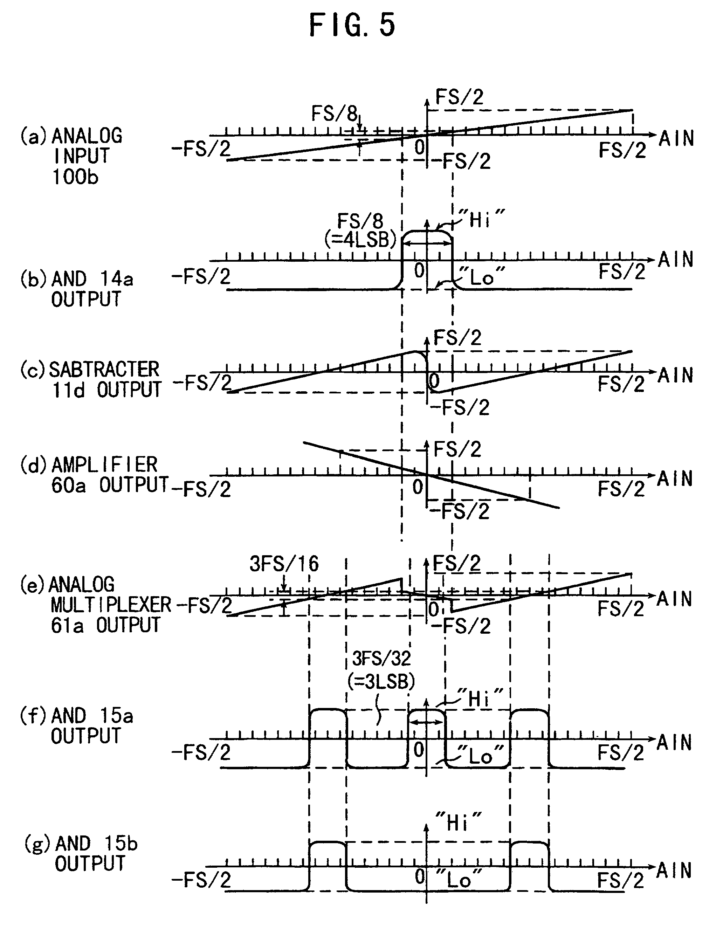

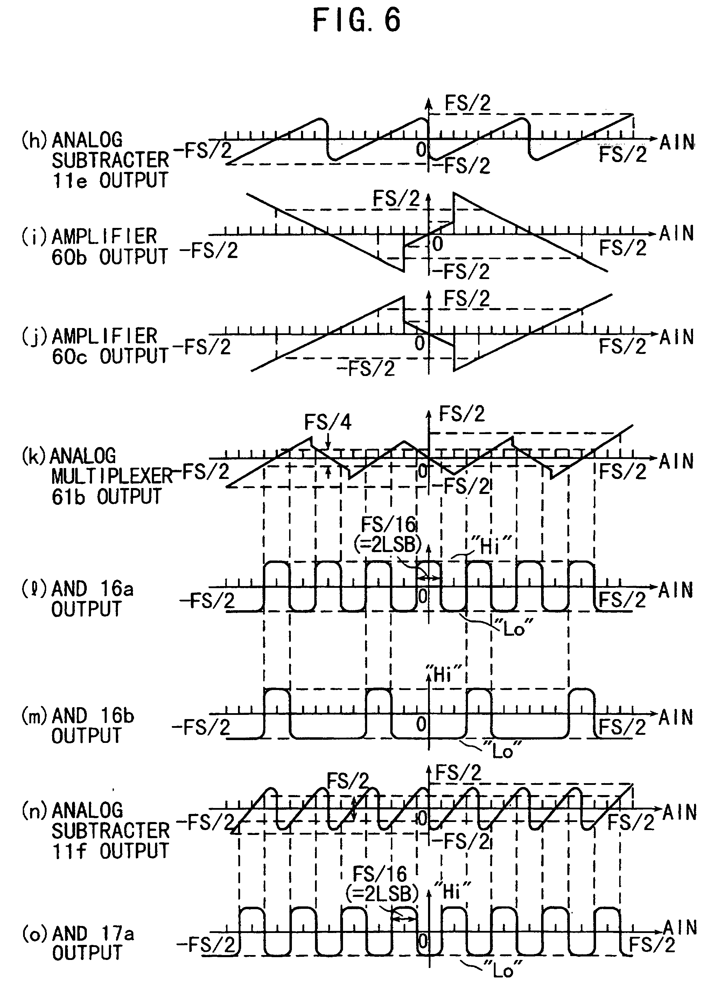

Figures 5 and 6 are diagrams including characteristic curves illustrating operations of the device shown in Figure 4.

In those figures, (a) shows analog input signal 100b from -FS/2 to +FS/2, (b) the output of AND circuit 14a, (c) the output of subtracter 11d, (d) the output of amplifier 60a, and (e) the output of analog multiplexer 61a. Also, (f) and (g) show the outputs of AND circuits 15a and 15b respectively, (h) the output of subtracter 11e, (i) and (j) the outputs of amplifiers 60b and 60c respectively, (k) the output of analog multiplexer 61b. In addition, (l) and (m) show the outputs of AND circuits 16a and 16b respectively, (n) the output of subtracter 11f, and (o) the output of AND circuit 17a.

Comparator 8a judges zero-crossing of analog input signal 100b and outputs the result to latch circuit 9a, D/A converter 10a, and EOR circuit 18. D/A converter 10a converts the output of comparator 8a into an analog signal and outputs the signal to subtracter 11d. Subtracter 11d subtracts the output of D/A converter 10a from analog input signal 100b and sends out an output obtained by amplifying twice the subtraction result.

Window comparator 50e outputs, as shown in (b) of Figure 5, a "high level" signal in window width of FS/8 in each vicinity of "zero" of analog input signal 100b shown in (a) of Figure 5.

Comparator 8b judges zero-crossing of the output of subtracter 11d and outputs the judged result to D/A converter 10b, and EOR circuits 18 and 19. D/A converter 10b converts the output of comparator 8b into an analog signal and outputs the signal to subtracter 11e. Subtracter 11e subtracts the output of D/A converter 10b from the output of subtracter 11d and sends out an output obtained by amplifying twice the subtraction result.

Analog multiplexer 61a composes the signal obtained by amplifying analog input signal 100b by -2 with amplifier 60a and the output of subtracter 11d. In detail, analog multiplexer 61a selects the output of amplifier 60a shown in (d) of Figure 5 at the interval where the output of window comparator 50e (AND circuit 14a) is at "high level." It selects the output of subtracter 11d shown in (c) of Figure 5 at the interval where the output of window comparator 50e is at "low level." And it creates the code changing waveform shown in (e) of Figure 5, and gives its output to window comparator 50f as input.

Window comparator 50f outputs, as shown in (f) of Figure 5, "high level" signals in the window width of 3FS/32 in each vicinity of "zero" of the input signal from AND circuit 15a. Window comparator 50f also outputs, as shown in (g) of Figure 5, "high level" signals in the window width of 3FS/32 in each vicinity of "zero" of the input signal from AND circuit 15b excepting the interval where the output of window comparator 50e is at "high level."

Comparator 8c judges zero-crossing of the output of subtracter 11e and outputs the judged result to D/A converter 10c, and EOR circuits 19 and 20. D/A converter 10c converts the output of comparator 8c into an analog signal and outputs the signal to subtracter 11f. Subtracter 11f subtracts the output of D/A converter 10c from the output of subtracter 11e and sends out an output obtained by amplifying twice the subtraction result.

Analog multiplexer 61b composes the signals obtained by amplifying the output of analog multiplexer 61a by -2 and +2 with amplifiers 60b and 60c respectively and the output of subtracter 11e. In detail, analog multiplexer 61b selects the output of amplifier 60b shown in (i) of Figure 6 at the interval where the output of AND circuit 15b in window comparator 50f is at "high level." Analog multiplexer 61b also selects the output of amplifier 60c shown in (j) of Figure 6 at the interval where the output of window comparator 50e is at "high level." It also selects the output of subtracter 11e shown in (h) of Figure 6 at the interval where both outputs of window comparators 50e and 50f are at "low level," creates the code changing waveform shown in (k) of Figure 6, and gives its output to window comparator 50g as input.

Window comparator 50g outputs, as shown in (l) of Figure 6, "high level" signals from AND circuit 16a in the window width of FS/16 in each vicinity of "zero" of the input signal. Window comparator 50g also outputs, as shown in (m) of Figure 6, "high level" signals from AND circuit 16b in the window width of FS/16 in each vicinity of "zero" of the input signal excepting the interval where the output of AND circuit 15a in window comparator 50f is at "high level."

Comparator 8d judges zero-crossing of the output of subtracter 11f and outputs the result to EOR circuit 20.

Also, window comparator 50h (AND circuit 17a) outputs, as shown in (o) of Figure 6, a "high level" signal in the window width of FS/16 in each vicinity of "zero" of the input signal shown in (n) of Figure 6.

After that, similar to conventional devices, EOR circuits 18 to 20 output gray codes including the above spike-like noise of intermediate bits in digital output signal 101b.

And error correction circuit 51 rejects spike-like noise in gray codes by correcting the portions where the above spike-like noise is generated using the outputs of window comparators.

As seen above, code-changing waveforms are created including code changes at the previous stages in waveform composition circuit 60. So, window widths (widths of detecting each vicinity of code changing points) of window comparators 50e to 50h can be set freely to increase the window width for upper bits and increase accuracy.

The voltage accuracy at later stages can be made less severe by increasing the gains of subtracters 11d to 11f and amplifiers 60a to 60c two-fold and the circuits can also be made simpler.

### (2) Second Embodiment

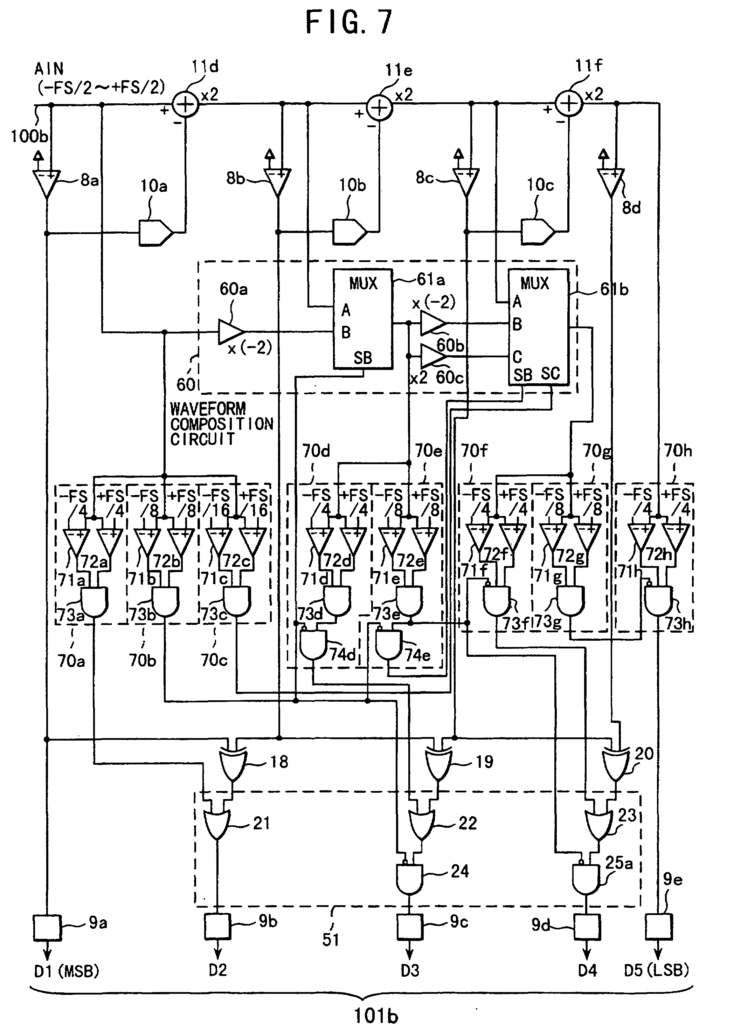

Figure 7 shows a configuration drawing that indicates a second embodiment of the present invention. In this figure, to the components identical to those shown in Figures 1-4, the same signs as those in Figures 1-4 are given and so description of those will be omitted.

In Figure 7, numerals 71a to 71h and 72a to 72h show comparators and numerals 25a, 73a to 73h, 74d, and 74e show logical product circuits (hereafter called AND circuits).

Comparators 71a, 72a and AND circuit 73a compose window comparator 70a. Comparators 71b, 72b and AND circuit 73b compose window comparator 70b. Comparators 71c, 72c and AND circuit 73c compose window comparator 70c. Window comparators 70a to 70c construct a means for detecting each vicinity of the code changing points.

Comparators 71d and 72d and AND circuits 73d and 74d compose window comparator 70d. Comparators 71e and 72e and AND circuits 73e and 74e compose window comparator 70e. Window comparators 70d and 70e construct a means for detecting each vicinity of the code changing points.

Comparators 71f, 72f and AND circuit 73f compose window comparator 70f. Comparators 71g, 72g and AND circuit 73g compose window comparator 70g. Window comparators 70f and 70g construct a means for detecting each vicinity of the code changing points.

Comparators 71h, 72h and AND circuit 73h compose window comparator 70h. Window comparator 70h constructs a means for detecting each vicinity of the code changing points.

As for connections, the basic part is the same as those in Figure 1 and the differences are as follows:

Subtracters 11d to 11f are provided in place of subtracters 11a to 11c and send out each output obtained by amplifying twice the subtraction result respectively.

Analog input signal 100b is input to the non-inverted input terminals of comparators 8a and 71a to 71c, the inverted input terminals of comparators 72a to 72c, the addition input terminal of subtracter 11d, and amplifier 60a.

Also, the outputs of comparators 71a and 72a are connected to the input terminals of AND circuit 73a respectively, and the output of AND circuit 73a is connected to one input terminal of OR circuit 21. The outputs of comparators 71b and 72b are connected to the input terminals of AND circuit 73b respectively, and the output of AND circuit 73b is connected to the negative logic input terminals of AND circuits 24, 74d and 74e and the selection terminal of analog multiplexer 61a. The outputs of comparators 71c and 72c are connected to the input terminals of AND circuit 73c respectively, and the output of AND circuit 73c is connected to one selection terminal of analog multiplexer 61b.

The output of amplifier 60a is input to one input terminal of analog multiplexer 61a.

The output of subtracter 11d is connected to the non-inverted input terminal of comparator 8b, the addition input terminal of subtracter 11e, and the other input terminal of analog multiplexer 61a. The output of analog multiplexer 61a is connected to the non-inverted input terminals of comparators 71d and 71e, the inverted input terminals of comparators 72d and 72e, and amplifiers 60b and 60c.

In addition, the outputs of comparators 71d and 72d are connected to the input terminals of AND circuit 73d respectively. The output of AND circuit 73d is connected to the positive logic input terminal of AND circuit 74d, and the output of AND circuit 74d is connected to one input terminal of OR circuit 22. The outputs of comparators 71e and 72e are connected to the input terminals of AND circuit 73e respectively and the output of AND circuit 73e is connected to the positive logic input terminal of AND circuit 74e and the negative logic input terminals of AND circuits 25a and 73f. The output of AND circuit 74e is connected to the other selection terminal of analog multiplexer 61b. And the output of OR circuit 23 is connected to the positive logic input terminal of AND circuit 25a and the output of AND circuit 25a is connected to latch circuit 9d.

The outputs of amplifiers 60b and 60c are input to each input terminal of analog multiplexer 61b respectively.

The output of subtracter 11e is connected to the non-inverted input terminal of comparator 8c, the addition input terminal of subtracter 11f, and one input terminal of analog multiplexer 61b. The output of analog multiplexer 61b is connected to the non-inverted input terminals of comparators 71f and 71g and to the inverted input terminals of comparators 72f and 72g.

Further, the outputs of comparators 71f and 72f are connected to each positive logic input terminal of AND circuit 73f respectively, and the output of AND circuit 73f is connected to one input terminal of OR circuit 23. The outputs of comparators 71g and 72g are connected to each input terminal of AND circuit 73g respectively. The output of AND circuit 73g is connected to the negative logic input terminal of AND circuit 73h.

The output of subtracter 11f is connected to the non-inverted input terminals of comparators 8d and 71h and the inverted input terminal of comparator 72h.

The outputs of comparators 71h and 72h are connected to each positive logic input terminal of AND circuit 73h and the output of AND circuit 73h is connected to latch circuit 9e.

Further, the outputs of latch circuits 9a to 9e are output as digital output signal 101b.

Voltages of +FS/4, +FS/8, +FS/16, +FS/4, +FS/8, +FS/4, +FS/8, and +FS/4 are applied to the non-inverted input terminals of comparators 72a to 72h respectively. Also, voltages of -FS/4, -FS/8, -FS/16, -FS/4, -FS/8, -FS/4, -FS/8, and -FS/4 are applied to the inverted input terminals of comparators 71a to 71h respectively.

Operations of such a device will be described below.

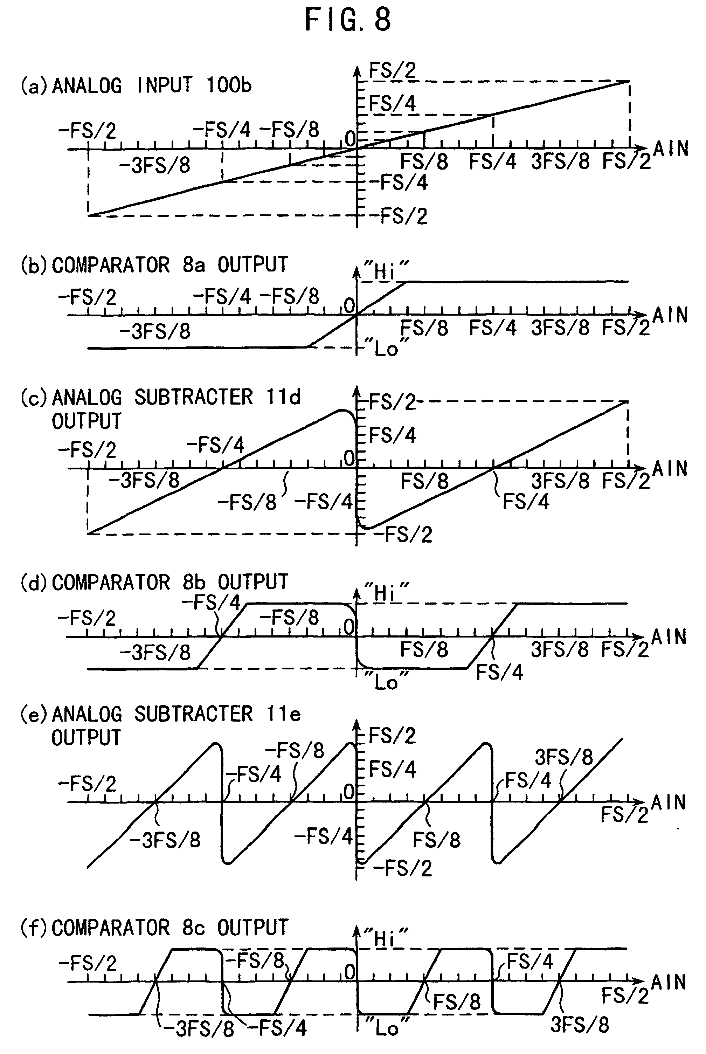

Figures 8 to 11 are diagrams including characteristic curves illustrating operations of the device shown in Figure 7.

In Figure 8, (a) shows analog input signal 100b from -FS/2 to +FS/2, (b) the output of comparator 8a, (c) the output of subtracter 11d, (d) the output of comparator 8b, (e) the output of subtracter 11e, and (f) the output of comparator 8c.

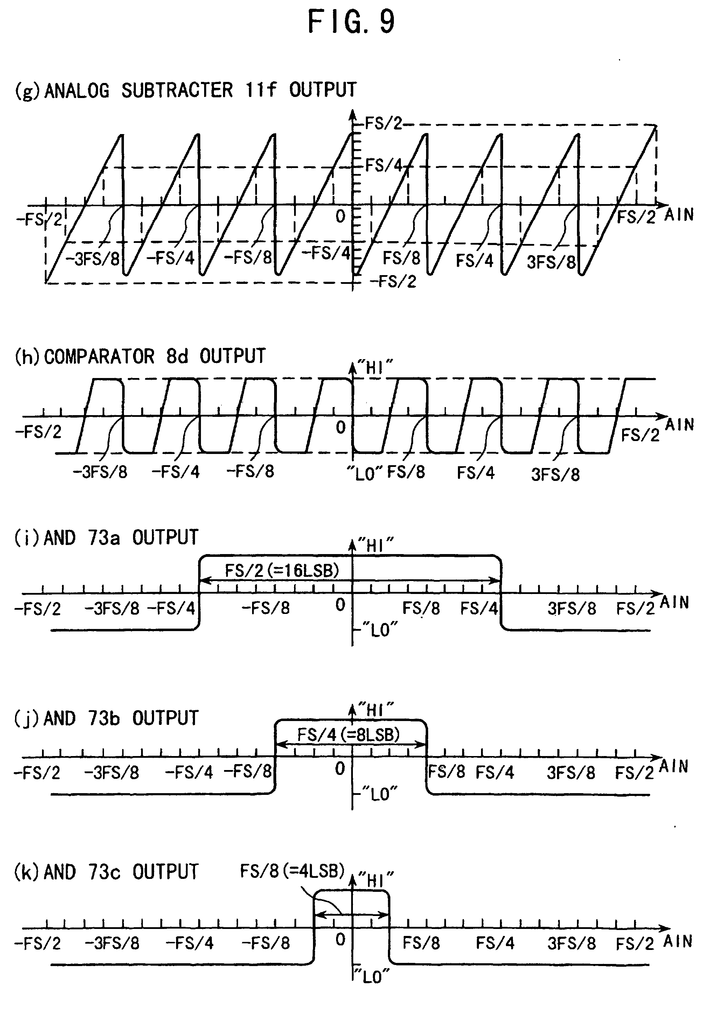

In Figure 9, (g) shows the output of subtracter 11f, (h) the output of comparator 8d, and (i) to (k) the outputs of AND circuits 73a to 73c respectively.

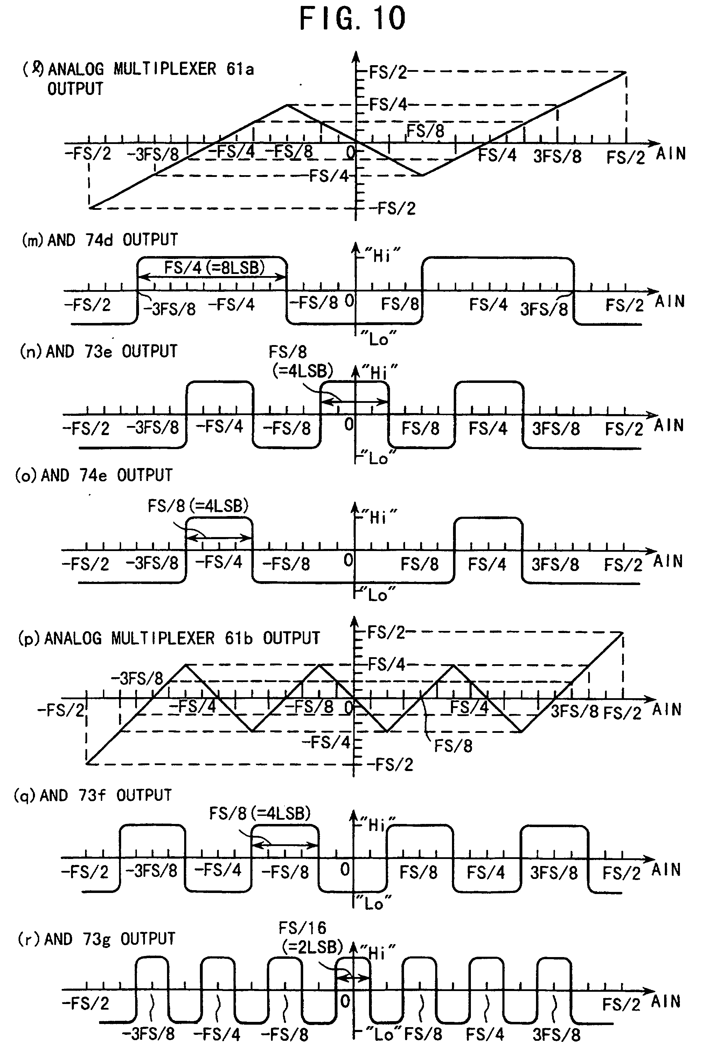

In Figure 10, (l) shows the output of analog multiplexer 61a, (m) to (o) the outputs of AND circuits 74d, 73e and 74e respectively, (p) the output of analog multiplexer 61b, and (q) and (r) the outputs of AND circuits 73f and 73g.

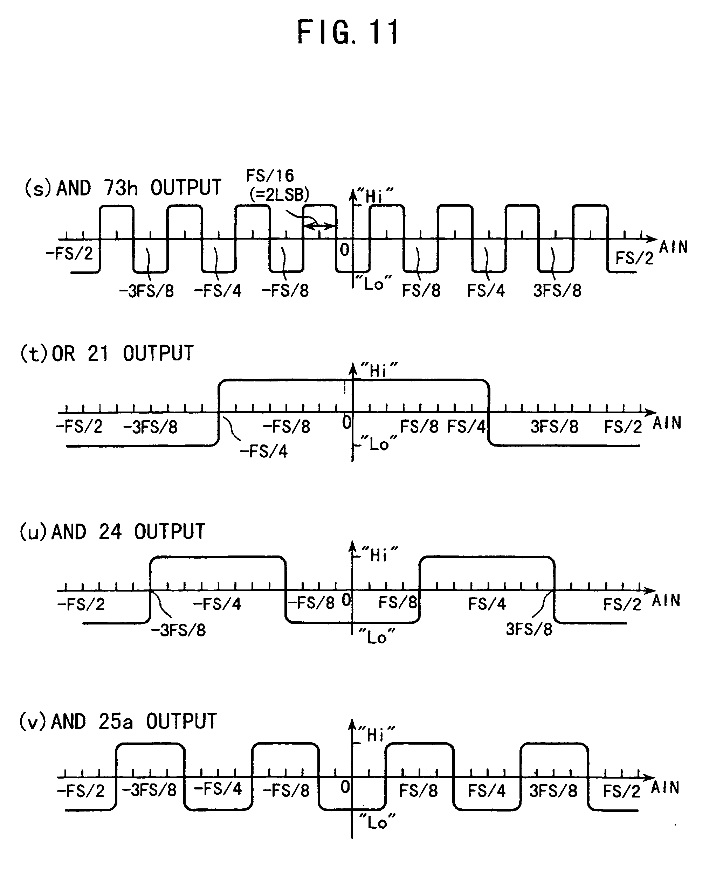

Further, in Figure 11, (s) shows the output of AND circuit 73h, (t) the output of OR circuit 21, and (u) and (v) the outputs of AND circuits 24 and 25a respectively.

Comparator 8a judges zero-crossing of analog input signal 100b and sends out the judged result to latch circuit 9a, D/A converter 10a and EOR circuit 18. D/A converter 10a converts the output of comparator 8a into an analog signal and outputs the signal to subtracter 11d. Subtracter 11d subtracts the output of D/A converter 10a from analog input signal 100b and sends an output obtained by amplifying twice the subtraction result.

Window comparator 70a outputs, as shown in (i) of Figure 9, a "high level" signal in the window width of FS/2 in each vicinity of "zero" of analog input signal 100b shown in (a) of Figure 8. The output of AND circuit 73a is used for rejecting spike-like noise in the second bit from MSB.

Window comparator 70b outputs, as shown in (j) of Figure 9, a "high level" signal in the window width of FS/4 in each vicinity of "zero" of analog input signal 100b shown in (a) of Figure 8. The output of AND circuit 73b is used for rejecting spike-like noise in the third bit from MSB.

Window comparator 70c outputs, as shown in (k) of Figure 9, a "high level" signal in the window width of FS/8 in each vicinity of "zero" of analog input signal 100b shown in (a) of Figure 8.

Comparator 8b judges zero-crossing of the output of subtracter 11d and sends the output to D/A converter 10b and EOR circuits 18 and 19. D/A converter 10b converts the output of comparator 8b into an analog signal and outputs the signal to subtracter 11e. Subtracter 11e subtracts the output of D/A converter 10b from the output of subtracter 11d and sends an output obtained by amplifying twice the subtraction result.

Analog multiplexer 61a composes the signal obtained by amplifying analog input signal 100b by -2 with amplifier 60a and the output of subtracter 11d. In detail, analog multiplexer 61a selects the output of amplifier 60a at the interval where the output of window comparator 70b (AND circuit 73b) is at "high level." Analog multiplexer 61a also selects the output of subtracter 11d shown in (c) of Figure 8 at the interval where the output of window comparator 70b is at "low level," creates the code changing waveform shown in (l) of Figure 10, and inputs its output to window comparators 70d and 70e.

Window comparator 70d outputs a "high level" signal from AND circuit 73d in the window width of FS/4 in each vicinity of "zero" of the input signal. That is, as shown in (l) of Figure 10, the "high level" signal is obtained in the window width from -3FS/8 to +3FS/8. As shown in (m) of Figure 10, AND circuit 74d outputs "high level" signals in the window width of FS/4 in each vicinity of "zero" of the input signal excepting the interval where the output of window comparator 70b is at "high level." The output of AND circuit 74d is used for rejecting spike-like noise in the third bit from MSB.

Window comparator 70e outputs, as shown in (n) of Figure 10, a "high level" signal from AND circuit 73e in the window width of FS/8 in each vicinity of "zero" of the input signal. As shown in (o) of Figure 10, AND circuit 74e outputs "high level" signals in the window width of FS/8 in each vicinity of "zero" of the input signal excepting the interval where the output of window comparator 70b is at "high level." The output of AND circuit 73e is used for rejecting spike-like noise in the fourth bit from MSB.

Comparator 8c judges zero-crossing of the output of subtracter 11e and sends out the judged result to D/A converter 10c and EOR circuits 19 and 20. D/A converter 10c converts the output of comparator 8c into an analog signal and sends the analog signal to subtracter 11f. Subtracter 11f subtracts the output of D/A converter 10c from the output of subtracter 11e and sends an output obtained by amplifying twice the subtraction result.

Analog multiplexer 61b composes the signals obtained by amplifying the output of analog multiplexer 61a by -2 and +2 respectively with amplifiers 60b and 60c and the output of subtracter 11e. In detail, analog multiplexer 61b selects the output of amplifier 60b at the interval where the output of AND circuit 74e of window comparator 70e is at "high level." Analog multiplexer 61b also selects the output of amplifier 60c at the interval where the output of window comparator 70c is at "high level." It further selects the output of subtracter 11e shown in (e) of Figure 8 at the interval where both of the above window comparator outputs are at "low level." Analog multiplexer 61b, then creates the code changing waveform shown in (p) of Figure 10 and sends its output to the inputs of window comparators 70f and 70g.

Window comparator 70f outputs, as shown in (q) of Figure 10, "high level" signals from AND circuit 73f in the window width of FS/8 in each vicinity of "zero" of the input signal excepting the interval where the output of AND circuit 73e of window comparator 70e is at "high level." The output of AND circuit 73f is used for rejecting spike-like noise in the fourth bit from MSB.

Window comparator 70g outputs, as shown in (r) of Figure 10, "high level" signals from AND circuit 73g in the window width of FS/16 in each vicinity of "zero" of the input signal. The output of AND circuit 73g is used for rejecting noise in LSB.

Comparator 8d judges zero-crossing of the output of subtracter 11f and outputs the result to EOR circuit 20.

The output of window comparator 70h (AND circuit 73h) has the possibility of becoming "high level" in 15 positions as shown in (g) of Figure 9. However, since the portions where the output of window comparator 70g is at "high level" are excepted from the above 15 positions, the output of AND circuit 73h is as shown in (s) of Figure 11.

Similar to conventional devices, the outputs of EOR circuits 18 to 20 output gray codes having spike-like noise of intermediate bits within digital output signal 101b.

Error correction circuit 51 corrects the portions where spike-like noise is generated with the outputs of window comparators to reject spike-like noise in gray codes.

In other words, spike-like noise in (i) of Figure 3 can be rejected by being masked using the output of window comparator 70a. Spike-like noise in (j) of Figure 3 can be rejected by being masked using the outputs of window comparators 70b and 70d, and spike-like noise in (k) of Figure 3 by being masked using the outputs of window comparators 70e and 70f respectively.

As described above, the code changing waveforms are created including the code changes in the previous stages with waveform composition circuit 60. So, window widths (widths for detecting each vicinity of code changing points) of window comparators 70a to 70h can be set freely and wider window widths can be taken for upper bits. That is, effects due to noise can be made smaller to increase accuracy.

In addition, since window comparators 70a to 70g whose window widths are different in each stage are provided, window widths for rejecting noise can be made larger as far as possible in all bits. That is, effects due to noise can be made smaller as far as possible to increase accuracy.

The voltage accuracy at later stages can also be made less severe by increasing gains of subtracters 11d to 11f and amplifiers 60a to 60c two-fold and the circuits can also be made simpler. A configuration including amplifier functions in analog multiplexers may also be adopted.

### (3) Third Embodiment

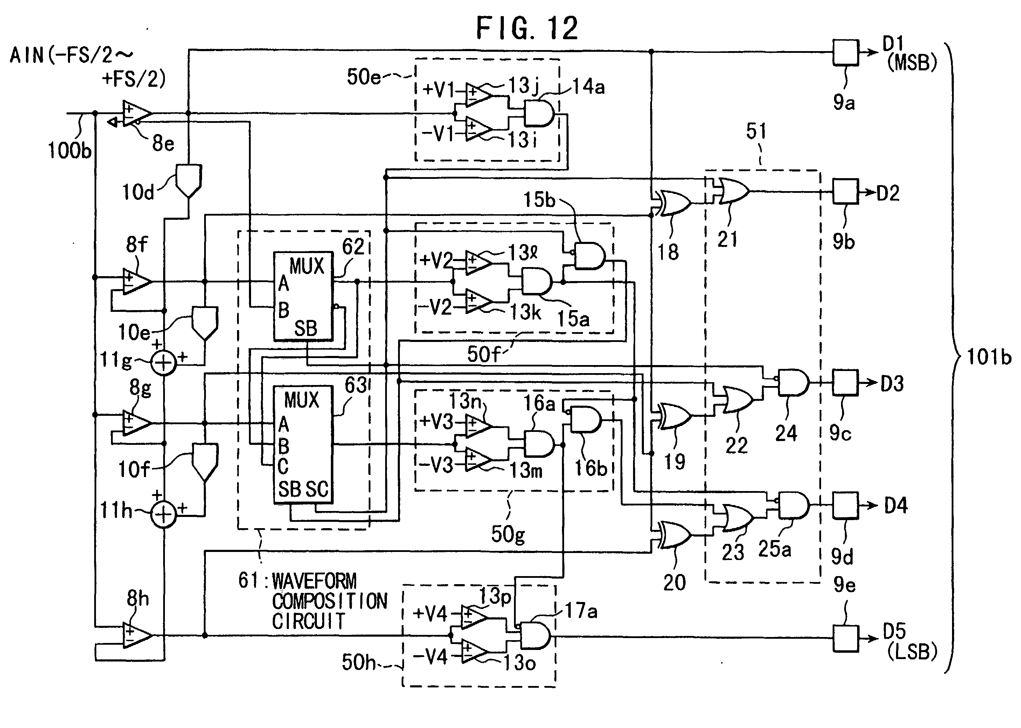

Figure 12 shows a configuration drawing that indicates a third embodiment of the present invention. In this figure, to the components identical to those shown in Figure 1, the same signs as those in Figure 1 are given and so description of those will be omitted.

In Figure 12, numerals 8e to 8h show comparators, numerals 10d to 10f D/A converters, numerals 11g and 11h adders, and numerals 13i to 13p comparators. Also, numerals 14a, 15a, 15b, 16a, 16b, 17a, and 25a show logical product circuits (hereafter called AND circuits), numerals 62 and 63 analog multiplexers, numeral 100b analog input signal, and numeral 101b digital output signal.

In addition, comparators 13i, 13j and AND circuit 14a construct window comparator (means for detecting each vicinity of code changing points) 50e. Comparators 13k, 13l and AND circuits 15a and 15b construct window comparator (means for detecting each vicinity of code changing points) 50f. Comparators 13m, 13n and AND circuits 16a and 16b construct window comparator (means for detecting each vicinity of code changing points) 50g. Comparators 13o, 13p and AND circuit 17a construct window comparator (means for detecting each vicinity of code changing points) 50h. Analog multiplexers 62 and 63 construct waveform composition circuit 61.

As for connections, the differences from those in Figure 1 are as follows:

Analog input signal 100b is input to the non-inverted input terminals of comparators 8e to 8h respectively.

The positive logic output of comparator 8e is connected to latch circuit 9a, D/A converter 10d, the non-inverted input terminal of comparator 13i, the inverted input terminal of comparator 13j, and one input terminal of EOR circuit 18. The negative logic output of comparator 8e is connected to one input terminal of analog multiplexer 62.

The output of D/A converter 10d is connected to the inverted input terminal of comparator 8f and one input terminal of adder 11g.

In addition, each output of comparators 13i and 13j is connected to the input terminals of AND circuit 14a respectively. The output of AND circuit 14a is connected to one input terminal of OR circuit 21, the negative logic input terminals of AND circuits 15b and 24, the selection terminal of analog multiplexer 62 and one selection terminal of analog multiplexer 63.

The output of comparator 8f is connected to D/A converter 10e, the other input terminal of EOR circuit 18, one input terminal of EOR circuit 19, and the other input terminal of analog multiplexer 62.

The positive logic output of analog multiplexer 62 is connected to the non-inverted input terminal of comparator 13k, the inverted input terminal of comparator 131, and one input terminal of analog multiplexer 63. The negative logic output of analog multiplexer 62 is connected to the second input terminal of analog multiplexer 63.

In addition, each output of comparators 13k and 131 is connected to AND circuit 15a respectively and the output of AND circuit 15a is connected to the positive logic input terminal of AND circuit 15b and to the negative logic input terminals of AND circuits 16b and 25a. The output of AND circuit 15b is connected to one input terminal of OR circuit 22 and the other selection terminal of analog multiplexer 63. The output of OR circuit 23 is connected to the positive logic input terminal of AND circuit 25a and the output of AND circuit 25a is connected to latch circuit 9d.

The output of D/A converter 10e is connected to the other input terminal of adder 11g and the output of adder 11g is connected to the inverted input terminal of comparator 8g and one input terminal of adder 11h.

The output of comparator 8g is connected to D/A converter 10f, the other input terminal of EOR circuit 19, one input terminal of EOR circuit 20, and the third input terminal of analog multiplexer 63.

The output of analog multiplexer 63 is connected to the non-inverted input terminal of comparator 13m and the inverted input terminal of comparator 13n.

Each output of comparators 13m and 13n is connected to the input terminals of AND circuit 16a respectively and the output of AND circuit 16a is connected to the positive logic input terminal of AND circuit 16b and the negative logic input terminal of AND circuit 17a. The output of AND circuit 16b is connected to one input terminal of OR circuit 23.

The output of D/A converter 10f is connected to the other input terminal of adder 11h and the output of adder 11h is connected to the inverted input terminal of comparator 8h.

The output of comparator 8h is connected to the non-inverted input terminal of comparator 13o, the inverted input terminal of comparator 13p, and the other input terminal of EOR circuit 20.

Each output of comparators 13o and 13p is connected to the other two positive logic input terminals of AND circuit 17a respectively and the output of AND circuit 17a is connected to latch circuit 9e.

Further, the outputs of latch circuits 9a to 9e are output as digital output signal 101b.

In addition, the inverted input terminal of comparator 8e is grounded. Voltages of +V1, +V2, +V3, and +V4 are applied to the non-inverted input terminals of comparators 13j, 13l, 13n, and 13p respectively and voltages of -V1, -V2, -V3 and -V4 are applied to the inverted input terminals of comparators 13i, 13k, 13m, and 13o respectively.

Voltage V1 is determined to be a value with which the window width of window comparator 50e becomes FS/8 at the differential operation interval of comparator 8e. Voltage V2 is determined to be a value with which the window width of window comparator 50f becomes 3FS/32 at the differential operation interval of comparators 8e and 8f. Voltage V3 is determined to be a value with which the window width of window comparator 50g becomes FS/16 at the differential operation interval of comparators 8e to 8g. Voltage V4 is determined to be a value with which the window width of window comparator 50h becomes FS/16 at the differential operation interval of comparator 8h.

Operations of such a device will be described below.

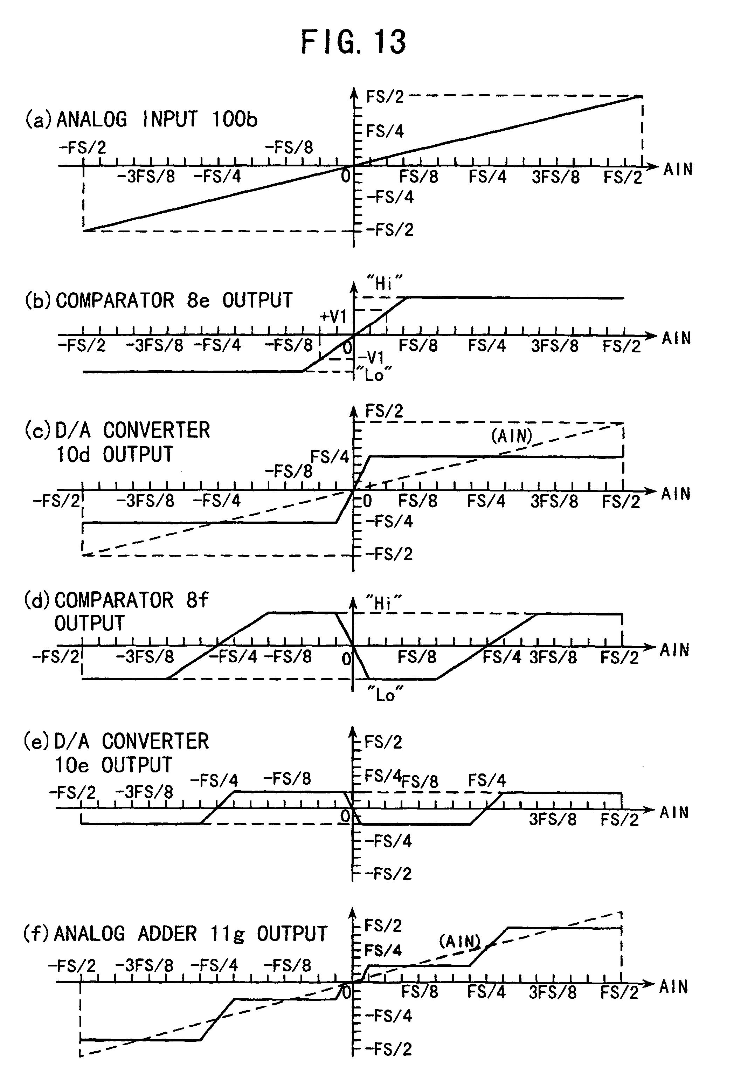

Figures 13 to 15 are diagrams including characteristic curves illustrating operations of the device shown in Figure 12.

In Figure 13, (a) shows analog input signal 100b of -FS/2 to +FS/2, (b) the output of comparator 8e, (c) the output of D/A converter 10d, (d) the output of comparator 8f, (e) the output of D/A converter 10e, and (f) the output of adder 11g.

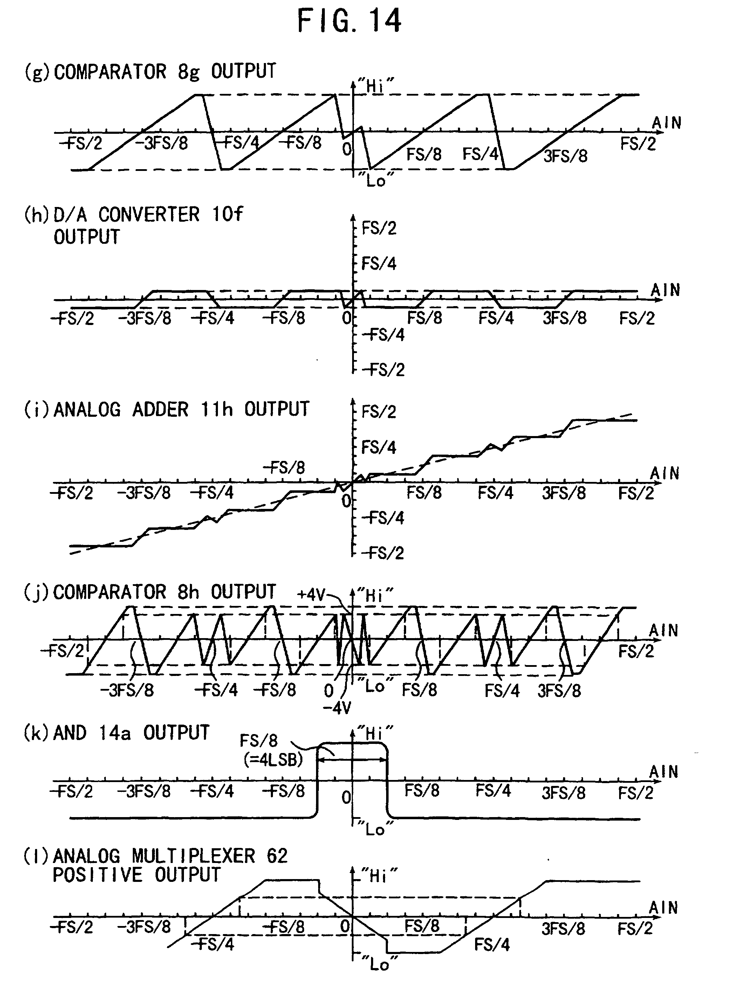

In Figure 14, (g) shows the output of comparator 8g, (h) the output of D/A converter 10f, (i) the output of adder 11h, (j) the output of comparator 8h, (k) the output of AND circuit 14a, and (l) the positive logic output of analog multiplexer 62.

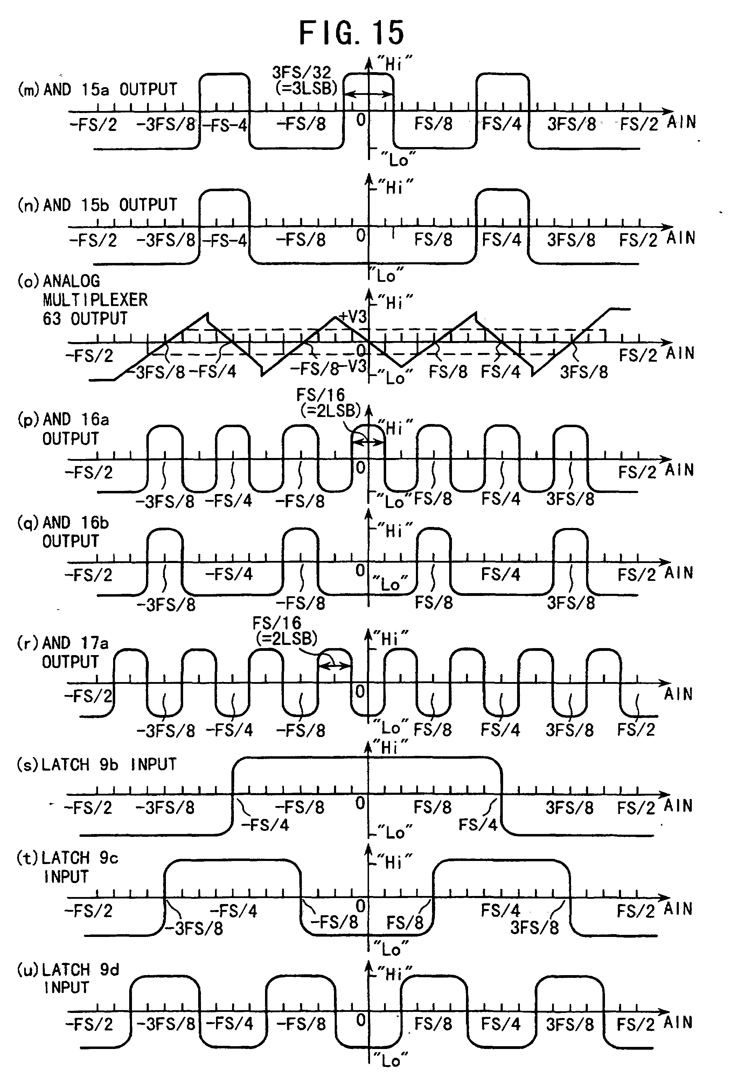

In Figure 15, (m) and (n) show the outputs of AND circuits 15a and 15b respectively, (o) the output of analog multiplexer 63, (p) to (r) the outputs of AND circuits 16a, 16b, and 17a respectively, and (s) to (u) each input of latch circuits 9b to 9d respectively.

Comparator 8e compares analog input signal 100b shown in (a) of Figure 13 with zero point and implements differential amplification as shown in (b) of Figure 13. In this case, a comparator having less gain than comparator 8a in the example of conventional devices is used as comparator 8e. Comparator 8e gives positive logic outputs to latch circuit 9a, D/A converter 10d, comparators 13i and 13j and EOR circuit 18, and negative logic output to analog multiplexer 62.

D/A converter 10d converts the positive logic output of comparator 8e into an analog signal as shown in (c) of Figure 13 and outputs this signal to comparator 8f and adder 11g.

Window comparator 50e outputs, as shown in (k) of Figure 14, a "high level" signal in the window width of FS/8 in each vicinity of "zero" of the output of comparator 8e shown in (b) of Figure 13.

Comparator 8f compares analog input signal 100b with the output of D/A converter 10d and implements differential amplification as shown in (d) of Figure 13. In addition, a comparator whose gain is smaller than that of comparator 8b used in conventional devices is used for comparator 8f. The output of comparator 8f is given to D/A converter 10e, EOR circuits 18 and 19, and analog multiplexer 62.

D/A converter 10e converts, as shown in (e) of Figure 13, the output of comparator 8f into an analog signal and outputs this signal to adder 11g. Adder 11g adds, as shown in (f) of Figure 13, the output of D/A converter 10d to the output of D/A converter 10e and outputs the result of addition to comparator 8g and adder 11h.

Analog multiplexer 62 composes the outputs of comparators 8e and 8f. In detail, analog multiplexer 62 selects the output of comparator 8e shown in (b) of Figure 13 at the interval where the output of window comparator 50e (AND circuit 14a) is at "high level." Analog multiplexer 62 also selects the output of comparator 8f shown in (d) of Figure 13 at the interval where the above window comparator output is at "low level," and creates the code changing waveform shown in (l) of Figure 14. This code changing waveform is input to window comparator 50f and analog multiplexer 63 and the inverted output of the code changing waveform is also input to analog multiplexer 63.

Window comparator 50f outputs, as shown in (m) of Figure 15, "high level" signals from AND circuit 15a in the window width of 3FS/32 in each vicinity of "zero" of the input signal. Window comparator 50f also outputs, as shown in (n) of Figure 15, "high level" signals from AND circuit 15b in the window width of 3FS/32 in each vicinity of "zero" of the input signal, excepting the interval where the output of window comparator 50e is at "high level."

Comparator 8g compares analog input signal 100b with the output of adder 11g and, as shown in (g) of Figure 14, implements differential amplification. In addition, a comparator whose gain is smaller than that of comparator 8c used in conventional devices is used for comparator 8g. The output of comparator 8g is given to D/A converter 10f, EOR circuits 19 and 20, and analog multiplexer 63.

D/A converter 10f converts, as shown in (h) of Figure 14, the output of comparator 8g into an analog signal and outputs this signal to adder 11h. Adder 11h adds, as shown in (i) of Figure 14, the output of D/A converter 10f to the output of adder 11g and outputs the result of addition to comparator 8h.

Analog multiplexer 63 composes the output of analog multiplexer 62 and the output of comparator 8g. In detail, analog multiplexer 63 selects the inverted output of analog multiplexer 62 at the interval where the output of AND circuit 15a in window comparator 50f is at "high level." Analog multiplexer 63 also selects the output of analog multiplexer 62 shown in (l) of Figure 14 at the interval where the output of window comparator 50e is at "high level." It further selects the output of comparator 8g shown in (g) of Figure 14 at the interval where both of the above window comparator outputs are at "low level." Analog multiplexer 63 also creates the code changing waveform shown in (o) of Figure 15, and inputs its output to window comparator 50g.

Window comparator 50g outputs, as shown in (p) of Figure 15, "high level" signals from AND circuit 16a in the window width of FS/16 in each vicinity of "zero" of the input signal. Window comparator 50g also outputs, as shown in (q) of Figure 15, "high level" signals from AND circuit 16b in the window width of FS/16 in each vicinity of "zero" of the input signal, excepting the intervals where the output of AND circuit 15a in window comparator 50f is at "high level."

Comparator 8h compares analog input signal 100b with the output of adder 11h and, as shown in (j) of Figure 14, implements differential amplification. In addition, a comparator whose gain is smaller than that of comparator 8d used in conventional devices is used for comparator 8h. The output of comparator 8h is given to AND circuits 13o and 13p and EOR circuit 20.

Window comparator 50h (AND circuit 17a) outputs, as shown in (r) of Figure 15, "high level" signals in the window width of FS/16 in each vicinity of "zero" of the input signal shown in (j) of Figure 14, excepting "high level" intervals of the output of AND circuit 16a in window comparator 50g.

Then, similar to conventional devices, the outputs of EOR circuits 18 to 20 output gray codes having spike-like noise of intermediate bits within digital output signal 101b.

Error correction circuit 51 corrects the portions where spike-like noise is generated with the outputs of window comparators to reject spike-like noise in gray codes.

As described above, the code changing waveforms are created including the code changes in the previous stages with waveform composition circuit 61. Thus, window widths (widths for detecting each vicinity of code changing points) of window comparators 50e to 50h can be set freely and wider window widths can be taken for upper bits. That is, effects due to noise can be made smaller to increase accuracy.

In addition, since inputs of comparators 8e to 8h are directly connected to analog input signal 100b, operation of subtracting the outputs of D/A converters from analog signals becomes unnecessary and settling is improved. Further, subtracters become unnecessary and this can reduce the scale of circuits and power consumption. Although adders to add outputs of D/A converters are newly added, a very simple configuration can be taken provided that addition is performed by current addition managed with connection only.

### (4) Fourth Embodiment

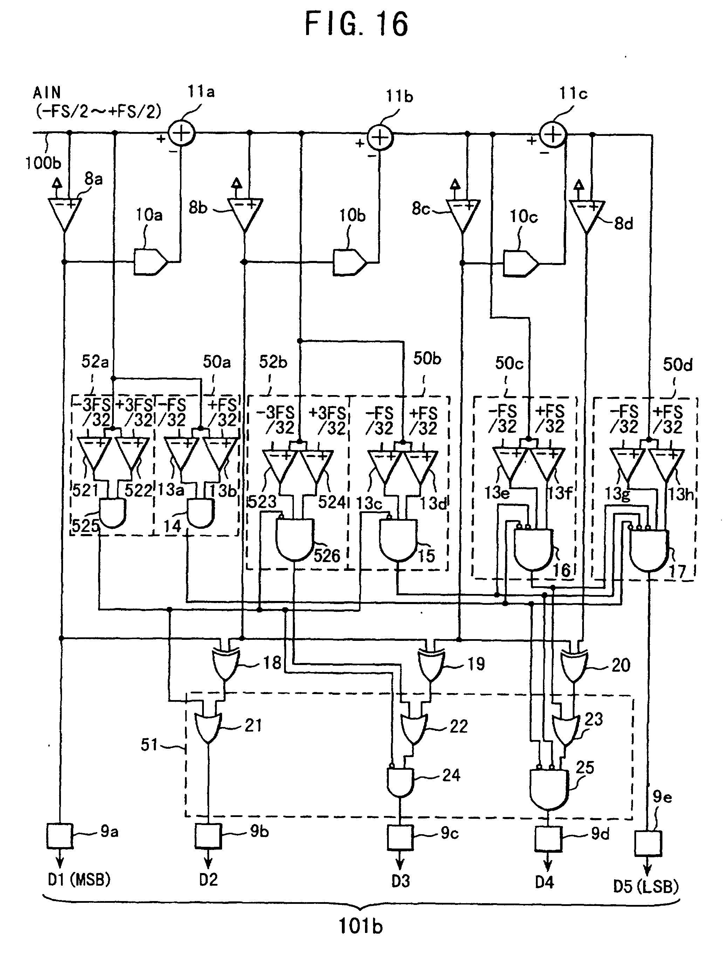

Figure 16 shows a configuration drawing that indicates a fourth embodiment of the present invention. In this figure, to the components identical to those shown in Figure 1, the same signs as those in Figure 1 are given and so description of those will be omitted.

In Figure 16, numerals 521 to 524 show comparators, numerals 525 and 526 AND circuits, numeral 100b an analog input signal and numeral 101b a digital output signal.

Window comparator 52a is composed of comparators 521 and 522 and AND circuit 525. Window comparators 50a and 52a construct a means for detecting each vicinity of code changing points respectively. Window comparator 52b is composed of comparators 523 and 524 and AND circuit 526. Window comparators 50b and 52b construct a means for detecting each vicinity of code changing points respectively.

As for connections, the basic portions are identical to those of Figure 1 and the differences are as follows:

Analog input signal 100b is input to the non-inverted input terminals of comparators 8a, 13a and 521, the inverted input terminals of comparators 13b and 522, and the addition input terminal of subtracter 11a.

Each output of comparators 521 and 522 is connected to the input terminals of AND circuit 525 respectively. The output of AND circuit 525 is connected to one input terminal of OR circuit 21, and negative logic input terminals of AND circuits 15 and 526, in place of AND circuit 14 in conventional devices. And the output of AND circuit 14 is connected to the negative logic input terminals of AND circuits 16 and 17.

In addition, the output of subtracter 11a is also connected to the non-inverted input terminal of comparator 523 and the inverted input terminal of comparator 524.

Each output of comparators 523 and 524 is connected to the input terminals of AND circuit 526 respectively and the output of AND circuit 526 is connected to one input terminal of OR circuit 22 in place of AND circuit 15 in conventional devices. And the output of AND circuit 15 is connected to the negative logic input terminals of AND circuits 16, 17, and 25.

Further, the outputs of latch circuits 9a to 9e are output as a digital output signal 101b.

A voltage of +3FS/32 is applied to the non-inverted input terminals of comparators 522 and 524 and a voltage of -3FS/32 is applied to the inverted input terminals of comparators 521 and 523.

Operation of such a device is described below.

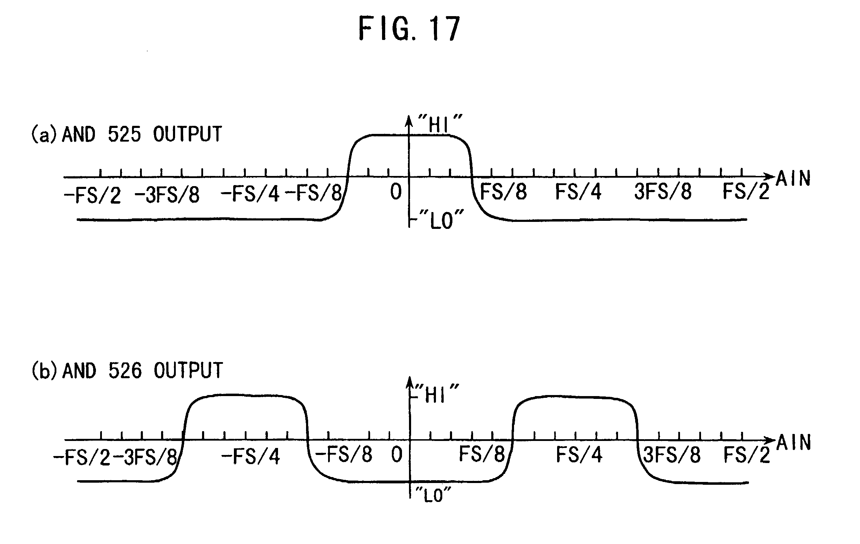

Figure 17 is a diagram including characteristic curves illustrating operations of the device shown in Figure 16.

Other characteristic curves are the same as those in Figures 2 and 3 except that (a) of Figure 2 shows analog input signal 100b.

In Figure 17, (a) shows the output of AND circuit 525 and (b) the output of AND circuit 526 respectively.

Each of comparators 8a to 8d judges zero-crossing of analog input signal 100b, of the output of subtracter 11a, of the output of subtracter 11b, and of the output of subtracter 11c respectively.

Window comparator 50a outputs "high level" signals in the window width of FS/16 in each vicinity of "zero" of analog input signal 100b as shown in (e) of Figure 2.

AND circuit 525 in window comparator 52a outputs "high level" signals in the window width of 3FS/16 in each vicinity of "zero" of analog input signal 100b as shown in (a) of Figure 17.

Window comparator 50b has, as shown in (b) of Figure 2, the possibility of outputting "high level" signals in the window width of FS/16 in each vicinity of "zero" and "±FS/4" of analog input signal 100b. However, since the output of comparator 52a in the preceding stage in the vicinity of "zero" of analog input signal 100b is at "high level," the output of window comparator 50b is at "high level" only in each vicinity of "±FS/4" as shown in (f) of Figure 2.

Window comparator 52b (AND circuit 526) has, as shown in (b) of Figure 2, the possibility of outputting "high level" signals in the window width of 3FS/16 in each vicinity of "zero" and "±FS/4" of analog input signal 100b. However, since the output of comparator 52a in the preceding stage in each vicinity of "zero" of analog input signal 100b is at "high level, " the output of window comparator 52b is at "high level" only in each vicinity of "±FS/4" as shown in (b) of Figure 17.

Window comparator 50c has, as shown in (c) of Figure 2, the possibility of outputting "high level" in seven positions. However, since the portions where the outputs of window comparators 50a and 50b in previous stages are at "high level" are excepted, the output of window comparator 50c becomes "high level" in four positions of window width of FS/16 as shown in (g) of Figure 2.

The output of window comparator 50d has, as shown in (d) of Figure 2, the possibility of becoming "high level" in 15 positions. However, since the portions where the outputs of window comparators 50a to 50c in previous stages are at "high level" are excepted, the output of window comparator 50d becomes "high level" in eight positions of window width of FS/16 as shown in (h) of Figure 2.

The outputs of EOR circuits 18 to 20 send out gray codes of intermediate bits in digital output signal 101b but it is known that they generate spike-like noise as shown in (i) to (k) of Figure 3. This is caused by the fact that changes from "high level" to "low level" or from low level" to "high level" in the outputs of comparators 8a to 8d are not steep.

Error correction circuit 51 herein rejects the above spike-like noise as shown in (m) to (o) of Figure 3 by correcting the portions where the above spike-like noise is generated using the outputs of window comparators.

That is, spike-like noise shown in (i), (j), and (k) of Figure 3 is rejected by being masked with the output of window comparator 52a, the outputs of window comparators 52a and 52b, and the outputs of window comparators 50a, 50b, and 50c respectively.

As seen above, since code changes are detected using window widths (width for detecting each vicinity of code changing points) in two stages by window comparators 50a, 50b, 52a and 52b, error rejection in error correction circuit 51 can be done selectively for bits. That is, effects due to noise can be made smaller to increase accuracy by taking wider window widths in upper bits.

In addition, the present invention may also be used in cascade A/D converters that output binary codes, not limited to cascade A/D converters that output gray codes. The present invention is also not limited by the number of output bits.

Further, the same effect as above can be obtained if gains of subtracters 11d to 11f and amplifiers 60a to 60c are larger than 1, not limited only to 2. Configurations having an amplifier function included in analog multiplexers may also be employed.

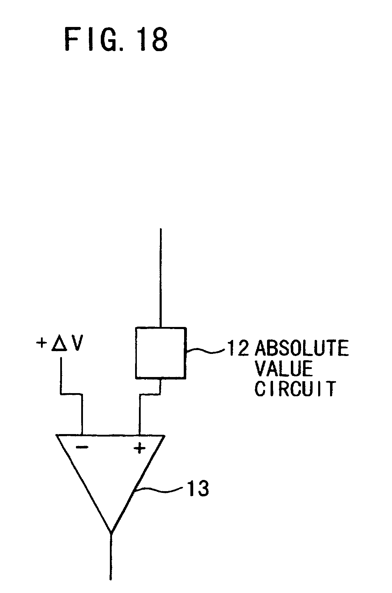

Furthermore, although configurations whose means for detecting each vicinity of code changing points is taken by window comparators 50a to 50h, 52a, 52b, and 70a to 70h are shown above, the configuration shown in Figure 18 may also be adopted. In other words, a window comparator is composed of absolute value circuit 12 and comparator 13. For example, this will be explained taking the device shown in Figure 4 as an example.

Absolute value circuit 12 obtains an absolute value by inputting analog input signal 100b, the output of analog multiplexer 61a, the output of analog multiplexer 61b, or the output of subtracter 11f.

In comparator 13, the output of absolute value circuit 12 is input to the positive logic input terminal and +ΔV (+FS/16, +3FS/32, +FS/8, or +FS/4) is input to the negative logic input terminal.

The output of comparator 13 becomes the output of AND circuit 14a, the output of AND circuit 15a, the output of AND circuit 16b, or the inputs to two positive logic input terminals of AND circuit 17a.

In the above description, the means for detecting each vicinity of code changing points that detects code changes using two or three stages of window widths (width for detecting each vicinity of code changing points) is shown. However, the means for detecting each vicinity of code changing points that detects code changes using window widths in four stages or more may be adopted.

## Claims

1. A cascade A/D converter configured by connecting in cascade a plurality of stages, each stage provided with a comparator (8a to 8d) to convert an analog input signal to a digital signal, a latch circuit (9a to 9d) to hold the output of this comparator, a D/A-converter (10a to 10d) to convert the output of the above comparator (8a to 8d) to an analog signal again, and a subtracter (11d to 11f) to subtract the output of the above D/A-converter (10a to 10d) from the above analog input signal; further comprising:
a plurality of means (50e to 50h) for detecting each vicinity of code changing points to detect code changes of the above plurality of comparators (8a to 8d) in widths for detecting each vicinity of code changing points in two stages or more, and
an error correction circuit (51) to reject noise generated at code changing points based on the outputs of the means (50e to 50h) for detecting each vicinity of code changing points,
**characterized in that**
said width of at least one means (50e to 50h) for detecting each vicinity of code changing points is wider than those of said means for detecting each vicinity of code changing points in two or more other stages.

2. A cascade A/D-converter according to claim 1 further **characterized by** comprising:
a waveform composition circuit (60) to compose code changing waveforms of the above comparators;
wherein said plurality of means (50) detect each vicinity of code changing points to detect code changes of the above comparators by receiving waveforms from this waveform composition circuit (60) as inputs.
said widths for detecting each vicinity of code changing points are greater in upper bits than in lower bits in said means (50) for detecting each vicinity of code changing points; and
wherein said waveform composition circuit (60) includes amplifiers (60a, 60b, 60c), each having the same gain as each subtracter (11d, 11e, 11f), receiving the input to the means (50) for detecting each vicinity of code changing points in the preceding stage as the input, and sending out its inverted or non-inverted output, and analog multiplexers (61a, 61b), each selecting the output of the above amplifier and the output of the subtracter (11d, 11e) in the preceding stage and sending out its output to the means for detecting each vicinity of code changing points in its own stage.

3. A cascade A/D-converter in accordance with claim 1 or 2, **characterized in that** gains of said subtracters (11d, 11e, 11f) and said amplifiers (60a, 60b) are made larger than 1.

4. A cascade A/D-converter in accordance with claim 2 or 3, **characterized in that** said comparator (8a to 8d) of each stage is adapted to compare the analog input signal with the analog signal for all upper bits and output a digital signal:
wherein said plurality of means (50) for detecting code changing points are configured so that the widths for detecting each vicinity of code changing points in upper bits are wider than those in lower bits;
wherein each of said analog multiplexers (61a, 61b) selects inverted or non-inverted input terminals of said comparators in the preceding stage and before, and sends its output to the means (50) for detecting each vicinity of code changing points in its own stage.

5. A cascade A/D-converter in accordance with any of claims 1 to 4, **characterized in that** said means (50) for detecting each vicinity of code changing points are configured using window comparators (13; 71).

6. A cascade A/D-converter in accordance with any of claims 1 to 5, **characterized in that** each of said means (50) for detecting each vicinity of code changing points comprises an absolute value circuit to receive each changing waveform from said waveform composition circuit (60) as an input and obtains an absolute value, and a second comparator to use the output of the above absolute value circuit for comparison.

## Patentansprüche

1. A/D-Kaskadenwandler, der durch Kaskadenschaltung einer Mehrzahl von Stufen konfiguriert ist, wobei jede Stufe versehen ist mit: einem Komparator (8a bis 8d), um ein analoges Eingangssignal in ein digitales Signal umzuwandeln, einer Latch-Schaltung (9a bis 9d), um die Ausgabe dieses Komparators zu halten, einem D/A-Wandler (10a bis 10d), um die Ausgabe des obigen Komparators (8a bis 8d) erneut in ein analoges Signal umzuwandeln, und einem Subtrahierer (11d bis 11f), um die Ausgabe des obigen D/A-Wandlers (10a bis 10d) von dem obigen analogen Eingangssignal zu subtrahieren; ferner mit:
einer Mehrzahl von Mitteln (50e bis 50a), um jede Nachbarschaft von Codeänderungspunkten zu erfassen, um Codeänderungen der obigen Mehrzahl von Komparatoren (8a bis 8e) in Breiten zum Erfassen jeder Nachbarschaft von Codeänderungspunkten in zwei Stufen oder mehr zu erfassen, und
eine Fehlerkorrekturschaltung (51), um an Codeänderungspunkten erzeugtes Rauschen basierend auf den Ausgaben der Mittel (50e bis 50a) zum Erfassen jeder Nachbarschaft von Codeänderungspunkten zurückzuweisen,
**dadurch gekennzeichnet, dass**
die Breite von mindestens einem Mittel (50e bis 50h) zum Erfassen jeder Nachbarschaft von Codeänderungspunkten breiter als diejenigen der Mittel zum Erfassen jeder Nachbarschaft von Codeänderungspunkten in zwei oder mehr anderen Stufen ist.

2. A/D-Kaskadenwandler gemäß Anspruch 1, ferner **gekennzeichnet durch**:
eine Signalverlaufzusammensetzungsschaltung (60), um Codeänderungssignalverläufe der obigen Komparatoren zusammen zu setzen;
wobei die Mehrzahl von Mitteln (50) jede Nachbarschaft von Codeänderungspunkten erfassen, um Codeänderungen der obigen Komparatoren **durch** Empfangen von Signalverläufen von dieser Signalverlaufzusammensetzungsschaltung (60) als Eingaben zu erfassen,
wobei die Breiten zum Erfassen jeder Nachbarschaft von Codeänderungspunkten größer in höheren Bits als in niedrigeren Bits in dem Mittel (50) zum Erfassen jeder Nachbarschaft von Codeänderungspunkten ist;
wobei die Signalverlaufzusammensetzungsschaltung (60) umfasst: Verstärker (60a, 60b, 60c), die jeweils den gleichen Verstärkungsfaktor wie jeder Subtrahierer (11d, 11e, 11f) aufweisen, die die Eingabe in die Mittel (50) zum Erfassen jeder Nachbarschaft von Codeänderungspunkten in den vorhergehenden Stufen als die Eingabe empfangen und ihre invertierte oder nicht invertierte Ausgabe aussenden, und analoge Multiplexer (61a, 61b), die jeweils die Ausgabe des obigen Verstärkers und die Ausgabe des Subtrahierers (11d, 11e) in der vorhergehenden Stufe auswählen und ihre Ausgabe an das Mittel zum Erfassen jeder Nachbarschaftencodeänderungspunkten in ihrer eigenen Stufe aussenden.

3. A/D-Kaskadenwandler in Übereinstimmung mit Anspruch 1 oder 2, **dadurch gekennzeichnet, dass** die Verstärkungsfaktoren der Subtrahierer (11d, 11e, 11f) und der Verstärker (60a, 60b) größer als eins sind.

4. A/D-Kaskadenwandler in Übereinstimmung mit Anspruch 2 oder 3, **dadurch gekennzeichnet, dass** der Komparator (8a bis 8d) jeder Stufe angepasst ist, um das analoge Eingangssignal mit dem analogen Signal für alle höheren Bits zu vergleichen und ein digitales Signal auszugeben;
wobei die Mehrzahl von Mitteln (50) zum Erfassen von Codeänderungspunkten konfiguriert sind, sodass die Breiten zum Erfassen jeder Nachbarschaft von Codeänderungspunkten in höheren Bits breiter als diejenigen in niedrigeren Bits sind;
wobei jeder der analogen Multiplexer (61a, 61b) invertierte oder nicht invertierte Eingangsanschlüsse der Komparatoren in der vorhergehenden Stufe und vorher auswählt, und seine Ausgabe an das Mittel (50) zum Erfassen jeder Nachbarschaft von Codeänderungspunkten in seiner eigenen Stufe sendet.

5. A/D-Kaskadenwandler in Übereinstimmung mit einem der Ansprüche 1 bis 4, **dadurch gekennzeichnet, dass** die Mittel (50) zum Erfassen jeder Nachbarschaft von Codeänderungspunkten mit Fensterkomparatoren (13; 71) konfiguriert sind.

6. A/D-Wandler in Übereinstimmung mit einem der Ansprüche 1 bis 5, **dadurch gekennzeichnet, dass** jedes der Mittel (50) zum Erfassen jeder Nachbarschaft von Codeänderungspunkten eine Absolutwertschaltung, um jeden sich ändernden Signalverlauf von der Signalverlaufzusammensetzungsschaltung (60) als eine Eingabe zu empfangen und einen Absolutwert zu erhalten, und einen zweiten Komparator, um die Ausgabe der obigen Absolutwertschaltung zum Vergleich zu verwenden, umfasst.

## Revendications

1. Convertisseur analogique-numérique à plusieurs étages configuré par la connexion en cascade de plusieurs étages, chaque étage étant doté d'un comparateur (8a à 8d) servant à convertir un signal d'entrée analogique en un signal numérique, un circuit de verrouillage (9a à 9d) servant à maintenir le signal de sortie de ce comparateur, un convertisseur numérique-analogique (10a à 10d) servant à convertir le signal de sortie du comparateur ci-dessus (8a à 8d) en un signal analogique de nouveau, et un soustracteur (11d à 11f) servant à soustraire le signal de sortie du convertisseur numérique-analogique ci-dessus (10a à 10d) du signal d'entrée analogique ci-dessus ; comprenant en outre :
une pluralité de moyens (50e à 50h) servant à détecter chaque voisinage de points de changement de code afin de détecter des changements de code pour la pluralité ci-dessus de comparateurs (8a à 8d) en largeurs de façon à détecter chaque voisinage de points de changement de code en deux étages ou plus, et
un circuit (51) de correction d'erreur servant à rejeter le bruit produit au niveau des points de changement de code sur la base des signaux de sortie des moyens (50e à 50h) servant à détecter chaque voisinage de points de changement de code ;
**caractérisé en ce que** ladite largeur d'au moins un moyen (50e à 50h) servant à détecter chaque voisinage de points de changement de code est plus large que celles desdits moyens servant à détecter chaque voisinage de points de changement de code en deux ou plus de deux autres étages.

2. Convertisseur analogique-numérique à plusieurs étages selon la revendication 1, **caractérisé en ce qu'**il comprend en outre:
un circuit (60) de composition de formes d'onde servant à composer des formes d'onde de changement de code des comparateurs ci-dessus ;
où ladite pluralité de moyens (50) détecte chaque voisinage de points de changement de code afin de détecter les changements de code des comparateurs ci-dessus par réception de formes d'onde venant de ce circuit de composition de formes d'onde (60) faisant fonction de signaux d'entrée,
lesdites largeurs servant à détecter chaque voisinage de points de changement de code sont plus grands en ce qui concerne les bits d'ordre supérieur qu'en ce qui concerne les bits d'ordre inférieur desdits moyens (50) servant à détecter chaque voisinage de points de changement de code ; et
où ledit circuit de composition de formes d'onde (60) comporte des amplificateurs (60a, 60b, 60c) ayant chacun le même gain que chaque soustracteur (11d, 11e, 11f), recevant le signal d'entrée appliqué aux moyens (50) servant à détecter chaque voisinage de points de changement de code dans l'étage précédent au titre du signal d'entrée et envoyant son signal de sortie inversé ou non inversé, et des multiplexeurs analogiques (61a, 61b) sélectionnant chacun le signal de sortie de l'amplificateur ci-dessus et le signal de sortie du soustracteur (11d, 11e) dans l'étage précédent et envoyant son signal de sortie aux moyens servant à détecter chaque voisinage de points de changement de code dans son propre étage.

3. Convertisseur analogique-numérique à plusieurs étages selon la revendication 1 ou 2, **caractérisé en ce que** les gains desdits soustracteurs (11d, 11e, 11f) et desdits amplificateurs (60a, 60b) sont plus grands que 1.

4. Convertisseur analogique-numérique à plusieurs étages selon la revendication 2 ou 3, **caractérisé en ce que** ledit comparateur (8a à 8d) de chaque étage est conçu pour comparer le signal d'entrée analogique avec le signal analogique relatif à tous les bits d'ordre supérieur et délivrer un signal numérique ;
où ladite pluralité de moyens (50) servant à détecter des points de changement de code est configurée de façon que les largeurs servant à détecter chaque voisinage de points de changement de code en ce qui concerne les bits d'ordre supérieur soient plus larges que celles se rapportant aux bits d'ordre inférieur ;
où chacun desdits multiplexeurs analogiques (61a, 61b) sélectionne des bornes d'entrée d'inversion ou de non-inversion dudit comparateur de l'étage précédent et avant, et envoie son signal de sortie aux moyens (50) servant à détecter chaque voisinage de points de changement de code de son propre étage.

5. Convertisseur analogique-numérique à plusieurs étages selon l'une quelconque des revendications 1 à 4, **caractérisé en ce que** lesdits moyens (50) servant à détecter chaque voisinage de points de changement de code sont configurés au moyen de comparateurs de fenêtre (13 ; 71).

6. Convertisseur analogique-numérique à plusieurs étages selon l'une quelconque des revendications 1 à 5, **caractérisé en ce que** chacun desdits moyens (50) servant à détecter chaque voisinage de points de changement de code comprend un circuit de prise de valeur absolue servant à recevoir chaque forme d'onde de changement venant dudit circuit (60) de composition de formes d'onde comme signal d'entrée et obtient une valeur absolue, et un deuxième comparateur destiné à utiliser le signal de sortie du circuit de prise de valeur absolu ci-dessus en vue d'une comparaison.
